# EUROPÄISCHE PATENTSCHRIFT

(11) **EP 3 414 836 B1**
(45) Veröffentlichungstag und Bekanntmachung des Hinweises auf die Patenterteilung: **18.11.2020**
(21) Anmeldenummer: 17713176.0
(22) Anmeldetag: 09.03.2017
(51) Int. Cl.: H03G 3/30, H04R 3/02, H04R 27/00

(54) **VERFAHREN UND ANORDNUNG ZUM STEUERN EINER AUSGABELAUTSTÄRKE WENIGSTENS EINER AKUSTISCHEN AUSGABEEINRICHTUNG**
METHOD AND ARRANGEMENT FOR CONTROLLING THE OUTPUT VOLUME OF AT LEAST ONE ACOUSTIC OUTPUT DEVICE
PROCÉDÉ ET SYSTÈME DE COMMANDE D'UN VOLUME SONORE D'ÉMISSION D'AU MOINS UN DISPOSITIF D'ÉMISSION ACOUSTIQUE

(30) Priorität: 30.03.2016 DE 102016205184
(43) Veröffentlichungstag der Anmeldung: 19.12.2018
(73) Patentinhaber: Siemens Mobility GmbH, 81739 München (DE)
(72) Erfinder: SCHMATZ, Klaus-Dieter, 91052 Erlangen (DE)
(86) Internationale Anmeldenummer: PCT/EP2017/055520
(87) Internationale Veröffentlichungsnummer: WO 2017/167562

(56) Entgegenhaltungen:
- JP-A- 2004 032 463
- JP-U- H0 684 500
- US-A1- 2007 058 820
- US-A1- 2013 029 685

## Beschreibung

Die Erfindung betrifft ein Verfahren zum Steuern einer Ausgabelautstärke wenigstens einer akustischen Ausgabeeinrichtung umfassend: Aufnehmen eines akustischen Sprachsignals mittels einer Sprecheinrichtung und Ausgeben des akustischen Sprachsignals mittels der wenigstens einen Ausgabeeinrichtung.

Die Aufnahme und Wiedergabe von akustischen Sprachsignalen in offenen und geschlossenen räumlichen Bereichen finden auf unterschiedlichen technischen Gebieten Anwendung. Beispiele sind die Verstärkung von Gesang bei Live-Konzerten sowie von Durchsagen an Flughäfen, Bahnhöfen, etc. Beispielsweise werden für die Vermittlung von Informationen an Personen, die sich in einem räumlichen Bereich aufhalten, Durchsage-Systeme verwendet, bei denen ein Ansager eine Durchsage spricht und die Durchsage mittels Ausgabeeinrichtungen im räumlichen Bereich akustisch ausgegeben wird. Insbesondere beim Betrieb von Schienenfahrzeugen im öffentlichen Personenverkehr werden Durchsagen durch Zugbegleiter getätigt, um Fahrgäste zu informieren, beispielsweise über den weiteren Reiseverlauf oder eine kommende Haltestation.

Bekannt sind Durchsage-Systeme mit einer in einem Schienenfahrzeug ortsfest angeordneten Zugbegleitersprechstelle, mittels derer Durchsagen getätigt werden können. Die Durchsage wird dabei während des Sprechens auf Lautsprechern im Schienenfahrzeug wiedergegeben. Die Lautsprecher sind an verschiedenen Orten im Fahrzeug derart verbaut, dass Fahrgäste die Durchsage akustisch wahrnehmen können. Diese Durchsage-Systeme sind in der Handhabung unflexibel, da sich der Zugbegleiter für jede Durchsage zu einem der ortsfest im Schienenfahrzeug angeordneten Zugbegleitersprechstellen bewegen muss. Hierfür müssen andere Tätigkeiten, wie beispielsweise die Fahrkartenkontrolle, unterbrochen werden.

US 2007/0058820 A1 beschreibt ein Mikrofon, welches Geräusche eines Sprechers aufnimmt, und einen Lautsprecher, welcher ein Geräuschsignal auf Basis der mittels des Mikrofons aufgenommenen Geräusche ausgibt. Ein Geräuschquellenpositionsdetektor detektiert die Position der Geräuschquelle. Entsprechend der Position der Geräuschquelle wird mittels eine Signalprozessors die Lautstärke, die Verzögerungszeit und Equalizer-Eigenschaften des mittels des Lautsprechers ausgegebenen Geräuschsignals gesteuert.

JP H06 84500 U2 beschreibt ein Fahrzeug mit mehreren im Fahrzeug verteilten Lautsprechern und mehreren im Fahrzeug verteilten Eingangsanschlüssen für den Anschluss eines Mikrofons. Die Position des Mikrofons korrespondiert im Wesentlichen zur Position des Eingangsanschlusses, an den das Mikrofon angeschlossen ist. Mittels eines Schalters wird detektiert, an welchen Eingangsanschluss das Mikrofon angeschlossen ist. Anhand der Detektion wird die Ausgabe der Lautsprecher in der Nähe des Mikrofons angepasst.

Der Erfindung liegt vor diesem Hintergrund die Aufgabe zugrunde, ein Verfahren zu schaffen, bei dem das Aufnehmen und Ausgeben des akustischen Sprachsignals besonders einfach und flexibel handhabbar ist.

Diese Aufgabe wird durch ein Verfahren der eingangs genannten Art gelöst, welches die Schritte umfasst:
Ermitteln eines Ortes der Sprecheinrichtung relativ zu der wenigstens einen Ausgabeeinrichtung, wobei die Ausgabelautstärke der wenigstens einen Ausgabeeinrichtung in Abhängigkeit des Ortes gesteuert wird, wobei die Ausgabeeinrichtung die Ausgabeeinrichtung eines Schienenfahrzeugs ist und der Ort der Sprecheinrichtung basierend auf wenigstens einem Ortsermittlungssignal ermittelt wird, welches von einem aktiven und/oder passiven Transponderelement ausgeht und von der Sprecheinrichtung empfangen wird.

Die Erfindung ist in den unabhängigen Ansprüchen 1 und 13 definiert.

Unter Ausgabelautstärke ist im Rahmen der vorliegenden Erfindung vorzugsweise eine Intensität des durch die Ausgabeeinrichtung ausgegebenen akustischen Sprachsignals zu verstehen. Das Aufnehmen des akustischen Sprachsignals mittels der Sprecheinrichtung umfasst vorzugsweise eine Umwandlung des akustischen Sprachsignals in ein elektromagnetisches Sprachsignal. Die Sprecheinrichtung ist weiter vorzugsweise mit der Ausgabeeinrichtung signaltechnisch derart verbunden, dass das elektromagnetische Sprachsignal an die Ausgabeeinrichtung übertragen werden kann. Das Ausgeben des akustischen Sprachsignals umfasst vorzugsweise eine Umwandlung des elektromagnetischen Sprachsignals in ein verstärktes akustisches Sprachsignal, welches von Personen in der Umgebung der Ausgabeeinrichtung wahrgenommen werden kann.

Die wenigstens eine Ausgabeeinrichtung ist vorzugsweise ortsfest innerhalb eines räumlichen Bereichs angeordnet. Weiter vorzugsweise ist der Ort der jeweiligen Ausgabeeinrichtung innerhalb des räumlichen Bereichs bekannt. Dadurch kann der Ort der Sprecheinrichtung relativ zu der Ausgabeeinrichtung ermittelt werden, indem der Ort der Sprecheinrichtung innerhalb des räumlichen Bereichs ermittelt wird.

Das Steuern umfasst vorzugsweise ein Verringern und/oder Erhöhen der Ausgabelautstärke. Vorzugsweise wird bei der Steuerung der Ausgabelautstärke der wenigstens einen Ausgabeeinrichtung in Abhängigkeit des Ortes eine Ausrichtung der Ausgabeeinrichtung berücksichtigt. Unter Ausrichtung der Ausgabeeinrichtung versteht der Fachmann vorzugsweise die Richtung, in der das akustische Sprachsignal mittels der Ausgabeeinrichtung ausgegeben wird.

Mit der Erfindung wurde erkannt, dass bei bisherigen Lösungen, in denen Durchsagen mittels mobiler Sprecheinrichtungen getätigt werden, eine Durchsage zunächst aufgenommen wird und erst nach Abschluss der Aufnahme durch Ausgabeeinrichtungen wiedergegeben wird. Insbesondere bei zeitlich langen Aufnahmen führt dies zu einer unbequemen Handhabung für eine Person, die die Durchsage tätigt.

Gemäß der Erfindung ist die Ausgabeeinrichtung eine Ausgabeeinrichtung eines Schienenfahrzeugs. Insbesondere beim Betrieb von Fahrzeugen im Personenverkehr ist es wünschenswert für das Bordpersonal, Durchsagen zur Vermittlung von Informationen an Fahrgäste zu tätigen. Hierbei ist zu berücksichtigen, dass besonders bei Fahrzeugen die räumlichen Gegebenheiten dergestalt sind, dass ein Abstand zwischen der Sprecheinrichtung und der Ausgabeeinrichtung vergleichsweise klein sein kann. Somit ist eine Steuerung der Ausgabelautstärke in Abhängigkeit des Ortes der Sprecheinrichtung bei Fahrzeugen besonders zweckmäßig und vorteilhaft.

Nach einer weiteren bevorzugten Ausführungsform der Erfindung wird die Ausgabelautstärke derart gesteuert, dass eine akustische Rückkopplung zwischen der wenigstens einen Ausgabeeinrichtung und der Sprecheinrichtung vermieden wird. Vorzugsweise kann eine akustische Rückkopplung dadurch vermieden werden, dass die Lautstärke von wenigstens einer Ausgabeeinrichtung, die in Richtung der Sprecheinrichtung ausgerichtet sind, verringert wird.

Gemäß der Erfindung wird der Ort der Sprecheinrichtung basierend auf wenigstens einem Ortsermittlungssignal ermittelt, welches von einem aktiven und/oder passiven Transponderelement ausgeht und von der Sprecheinrichtung empfangen wird. Das Transponderelement ist vorzugsweise in einem räumlichen Bereich, welcher für die Ausgabe des akustischen Sprachsignals vorgesehen ist, angeordnet. Weiter vorzugsweise sind die Transponderelemente derart im räumlichen Bereich angeordnet, dass zumindest ein Ortsermittlungssignal an jedem Ort im räumlichen Bereich empfangen wird. Den Begriff "passiv" versteht der Fachmann derart, dass das Transponderelement eine Ortsermittlungsinformation enthält, beispielsweise speichert, und mittels einer Ausleseeinrichtung, vorzugsweise eine Ausleseeinrichtung der Sprecheinrichtung, aktiv ausgelesen werden muss, um das Ortsermittlungssignal, welches die Ortsermittlungsinformation enthält, zu empfangen. Die Verwendung eines passiven Transponderelements hat den Vorteil, dass keine Energieversorgung für das jeweilige passive Transponderelement vorgesehen werden muss. Den Begriff "aktiv" versteht der Fachmann derart, dass das Transponderelement das Ortsermittlungssignal aktiv aussendet. Die Verwendung eines aktiven Transponderelements hat den Vorteil, dass keine Ausleseeinrichtung zum aktiven Auslesen des Transponderelements erforderlich ist. Die Sprecheinrichtung umfasst dann vorzugsweise eine Empfangseinheit zum Empfangen des von dem aktiven Transponderelement ausgesendeten Ortsermittlungssignals. Weiter vorzugsweise sendet das aktive Transponderelement das Ortsermittlungssignal in regelmäßigen zeitlichen Abständen aus.

Gemäß einer bevorzugten Weiterbildung der Erfindung empfängt die Sprecheinrichtung das Ortsermittlungssignal in Form eines elektromagnetischen Signals unter Anwendung des Bluetooth-Standards. Mit der Verwendung des Bluetooth-Standards kann eine einfache Implementierung des Aussendens und Empfangens sowie der weiteren Auswertung des Ortsermittlungssignals erzielt werden. Dabei können bereits standardisierte Routinen für die gewünschten Funktionen verwendet werden.

Gemäß einer weiteren bevorzugten Weiterbildung der Erfindung umfasst das passive Transponderelement ein RFID-Element und/oder das aktive Transponderelement ein Beacon-Element. Zum Auslesen des RFID-Elements (RFID: Radio-Frequency Identification) kann vorzugsweise ein elektromagnetisches Wechselfeld in das RFID-Element induziert und durch ein Antennenelement des RFID-Elements moduliert werden. Anhand des modulierten elektromagnetischen Wechselfeldes, welches von dem RFID-Element ausgeht, ist die Sprecheinrichtung in der Lage, das RFID-Element zu identifizieren. Das Beacon-Element sendet das Ortsermittlungssignal vorzugsweise unter Anwendung des Standards "Bluetooth Low Energy", weiter vorzugsweise unter Anwendung des iBeacon-Standards. Hierdurch kann ein energieeffizienter Betrieb des Beacon-Elements erzielt werden. Zudem kann auf standardgemäß, vordefinierte Eigenschaften des Ortsermittlungssignals zurückgegriffen werden und eine einfache Implementierung des Empfangs und der Weiterverarbeitung des Ortsermittlungssignals mittels der Sprecheinrichtung erzielt werden.

Bei einer weiteren bevorzugten Ausführungsform der Erfindung wird der Ort der Sprecheinrichtung basierend auf einer Intensität des Ortsermittlungssignals ermittelt. Vorzugsweise dient die Intensität des Ortsermittlungssignals als zusätzliche Information zu dem Ortsermittlungssignal, um den Ort der Sprecheinrichtung zu ermitteln. Weiter vorzugsweise wird anhand des Ortsermittlungssignals ein Ort des Transponderelements, von dem das Ortsermittlungssignal ausgeht, ermittelt. Die Intensität des Ortsermittlungssignals dient vorzugsweise zur Ermittlung des Ortes der Sprecheinrichtung relativ zu dem Transponderelement. Beide Informationen, nämlich Ort des Transponderelements sowie Ort der Sprecheinrichtung relativ zu dem Transponderelement, können zur Ermittlung des Ortes der Sprecheinrichtung relativ zu der Ausgabeeinrichtung verwendet werden, beispielsweise wenn der Ort der Ausgabeeinrichtung bekannt ist.

Nach einer weiteren bevorzugten Ausführungsform der Erfindung umfasst das Ortsermittlungssignal ein Identifikationssignal zum Identifizieren des Transponderelements. Dies stellt eine besonders zweckmäßige und einfache Ausbildung des Ortsermittlungssignals dar. Das Identifikationssignal identifiziert das Transponderelement vorzugsweise global eindeutig. Dazu ist in vorteilhafter Weise jedem Transponderelement ein eindeutiges Identifikationssignal zur Aussendung zugeordnet. Bei einer Ausbildung der Ausgabeeinrichtung als Ausgabeeinrichtung eines Fahrzeugs, ist vorzugsweise jedem Transponderelement innerhalb einer Flotte von Fahrzeugen eines Betreibers ein eindeutiges Identifikationssignal zur Aussendung zugeordnet. Ein Ort eines im Fahrzeug ortsfest angeordneten Transponderelements kann auf diese Weise anhand des Identifikationssignals ermittelt werden.

Vorzugsweise umfasst das Ortsermittlungssignal eine Mehrzahl von Identifikationssignalen. Der Ort der Sprecheinrichtung wird weiter vorzugsweise basierend auf Intensitäten von mehreren empfangenen Identifikationssignalen ermittelt. Vorzugsweise wird der Ort der Sprecheinrichtung relativ zum Transponderelement unter Anwendung von Triangulation ermittelt. Weiter vorzugsweise wird der Ort der Sprecheinrichtung relativ zu einer Längserstreckung eines räumlichen Bereichs, welcher für die Ausgabe des akustischen Sprachsignals vorgesehen ist, ermittelt. Dies hat den Vorteil, dass der Empfang von zwei Identifikationssignalen für die Bestimmung des Ortes der Sprecheinrichtung relativ zu den zwei Transponderelementen ausreicht.

In einer bevorzugten Weiterbildung der Erfindung wird anhand einer Zuordnungstabelle dem Identifikationssignal eine Transponder-Ortsinformation, welche für den Ort des Transponderelements repräsentativ ist, zugeordnet und der Ort der Sprecheinrichtung unter Verwendung der Transponder-Ortsinformation ermittelt. Vorzugsweise wird mittels einer Recheneinheit und/oder der Sprecheinrichtung basierend auf dem Identifikationssignal eine Anfrage an eine die Zuordnungstabelle bereitstellende Datenverarbeitungseinrichtung gesendet und die Transponder-Ortsinformation in Antwort auf die Anfrage bereitgestellt.

Nach einer weiteren bevorzugten Weiterbildung der Erfindung wird die Transponder-Ortsinformation durch eine Datenverarbeitungseinrichtung bereitgestellt, welche außerhalb des Transponderelements angeordnet ist. Dies ist vorteilhaft, da einfache Transponderelemente verwendet werden können, die in der Lage sind, das Identifikationssignal auszugeben. Zudem wird die Installation einer das erfindungsgemäße Verfahren ausführenden Anordnung vereinfacht. Wenn die Transponderelemente nämlich selbst die Transponder-Ortsinformation aussenden sollen, müssten die einzelnen Transponderelemente vor der Installation programmiert werden, um den jeweiligen Installationsort als Information auszugeben. Demgegenüber wird gemäß der Weiterbildung die Bereitstellung der Transponder-Ortsinformation in eine, vorzugsweise zentrale, Datenverarbeitungseinrichtung, welche außerhalb des Transponderelements angeordnet ist, verlagert.

Gemäß einer weiteren bevorzugten Ausführungsform der Erfindung wird basierend auf dem Ort aus einer Mehrzahl von Ausgabeeinrichtungen wenigstens eine Umgebungsausgabeeinrichtung ausgewählt, die in der Umgebung der Sprecheinrichtung, vorzugsweise mit einem Abstand von weniger als 10 m zur Sprecheinrichtung, angeordnet ist, wobei das Steuern der Ausgabelautstärke durch Steuern der Ausgabelautstärke der wenigstens einen Umgebungsausgabeeinrichtung erfolgt. Damit wird eine besonders einfache Implementierung des erfindungsgemäßen Verfahrens für eine Vermeidung von Rückkopplungen angegeben. Weiter vorzugsweise wird aus der Mehrzahl von Ausgabeeinrichtungen eine Umgebungsausgabeeinrichtung ausgewählt, welche den kleinsten Abstand zur Sprecheinrichtung aufweist.

Nach einer bevorzugten Weiterbildung der Erfindung ist das Steuern ein Einstellen, insbesondere Abschalten, der Ausgabelautstärke. Das Einstellen erfolgt vorzugsweise durch Verringern der Ausgabelautstärke der Umgebungsausgabeeinrichtung. Bei einem Abschalten der Ausgabelautstärke können Rückkopplungen besonders einfach und zuverlässig vermieden werden, da die Umgebungsausgabeeinrichtung das akustische Sprachsignal nicht ausgibt.

Nach einer weiteren bevorzugten Weiterbildung der Erfindung umfassen die Ausgabeeinrichtungen jeweils wenigstens eine Lautsprechereinheit und wenigstens eine Verstärkereinheit, wobei basierend auf dem Ort aus einer Mehrzahl Verstärkereinheiten wenigstens eine Umgebungsverstärkereinheit ausgewählt wird, die in der Umgebung der Sprecheinrichtung angeordnet ist, und das Steuern der Ausgabelautstärke durch Steuern der Ausgangsleistung der wenigstens einen Umgebungsverstärkereinheit erfolgt. Vorzugsweise dient eine der Mehrzahl von Verstärkungseinheiten zur Verstärkung des elektrischen Sprachsignals für eine Mehrzahl von Lautsprechereinheiten. Mit anderen Worten: Den jeweiligen Verstärkereinheiten sind jeweils mehrere Lautsprechereinheiten zugeordnet.

In einer weiteren bevorzugten Ausführungsform der Erfindung ist die Sprecheinrichtung ein mobiles Endgerät. Somit kann die Sprecheinrichtung von einer Person zur Tätigung von Durchsagen mitgeführt werden. Die Sprecheinrichtung ist vorzugsweise ein mobiles Endgerät eines Zugbegleiters. Das Endgerät hat vorzugsweise weitere Funktionen, beispielsweise Mobiltelefonie. Der Benutzer der Sprecheinrichtung ist somit in der Lage, ein bereits vorhandenes mobiles Endgerät zum Aufnehmen des akustischen Sprachsignals zu verwenden; das Mitführen einer Sprecheinrichtung als getrennte Einheit ist nicht erforderlich.

Die Erfindung betrifft ferner ein Schienenfahrzeug gemäß Anspruch 13.

Zu Ausgestaltungen, Weiterbildungen, Ausgestaltungsdetails und Vorteilen der erfindungsgemäßen Vorrichtung wird auf die Beschreibung zu den entsprechenden Verfahrensmerkmalen verwiesen.

Ausführungsbeispiele der Erfindung werden nun anhand der Zeichnungen erläutert. Es zeigen
- Figur 1: eine schematische Ansicht eines Schienenfahrzeugs in einer Querschnittsansicht gemäß einem Ausführungsbeispiel einer erfindungsgemäßen Anordnung und
- Figur 2: einen schematischen Aufbau des in Figur 1 gezeigten Ausführungsbeispiels der erfindungsgemäßen Anordnung.

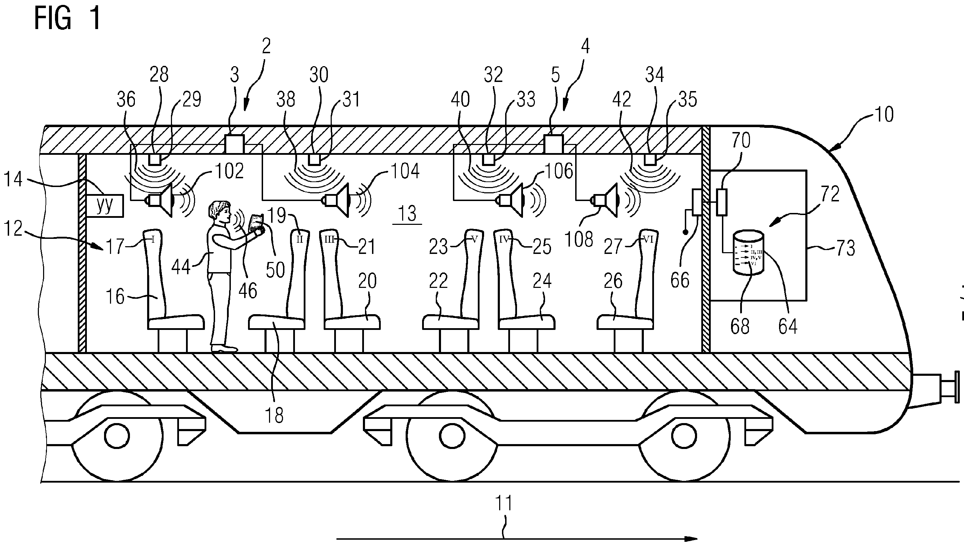

Figur 1 zeigt ein Schienenfahrzeug 10 in einer seitlichen Querschnittsansicht. In der betrachteten Ausführung ist das Schienenfahrzeug 10 als Triebzug ausgebildet, der zum Transport von Passagieren vorgesehen ist. In einer weiteren Ausbildung kann das Schienenfahrzeug 10 als ein Verband bestehend aus einer Lokomotive und mehreren Reisezugwagen ausgebildet sein.

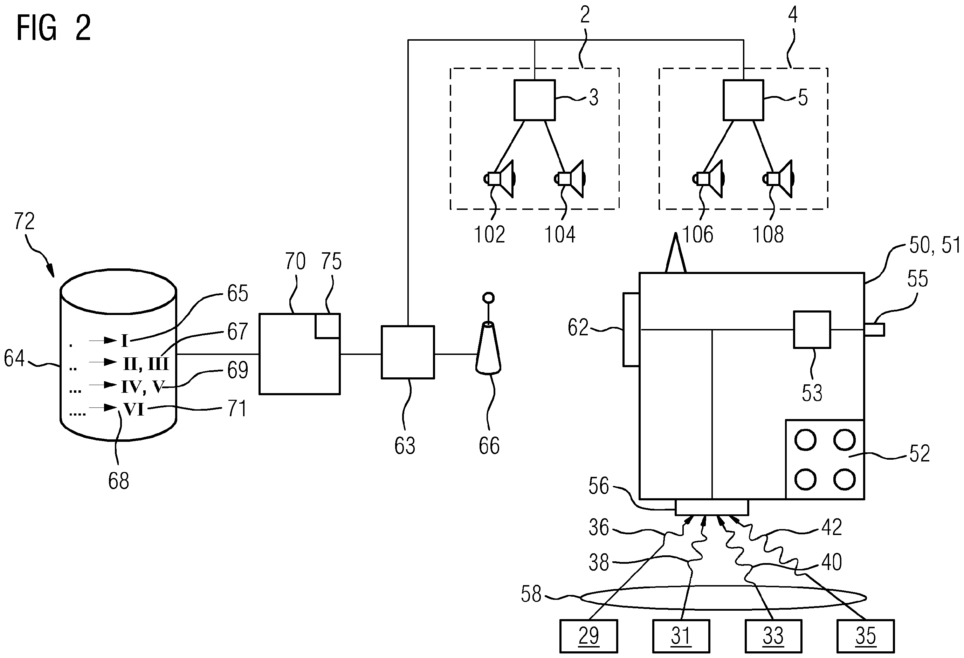

Figur 2 zeigt schematisch den Aufbau der Anordnung und den Informationsfluss zwischen den einzelnen Einrichtungen, Einheiten und Elementen der Anordnung.

Das Schienenfahrzeug 10 umfasst einen Wagen 12 mit einer Wagennummer 14. Der Wagen 12 hat in einem Fahrgastraum 13 mehrere Sitze 16, 18, 20, 22, 24, 26, welche jeweils eine zugehörige Sitznummer 17, 19, 21, 23, 25, 27 aufweisen.

In einem Deckenbereich des Fahrgastraums 13 sind mehrere Transponderelemente 28, 30, 32, 34 angeordnet. Die Transponderelemente 28, 30, 32, 34 sind jeweils als aktive Transponderelemente, nämlich als Beacon-Elemente 29, 31, 33, 35 ausgebildet. Die Transponderelemente 28, 30, 32, 34 können alternativ oder zusätzlich als passive Transponderelemente ausgebildet sein. Die Beacon-Elemente 29, 31, 33, 35 senden jeweils ein Identifikationssignal 36, 38, 40, 42 in regelmäßigen zeitlichen Abständen aus.

Im Fahrgastraum 13 sind zudem mehrere Ausgabeeinrichtungen 2, 4 angeordnet. Die Ausgabeeinrichtung 2 weist zur Ausgabe von akustischen Signalen zwei Lautsprechereinheiten 102, 104 und die Ausgabeeinrichtung 4 zwei Lautsprechereinheiten 106, 108 auf.

Ein Zugbegleiter 44, der sich im Fahrgastraum 13 aufhält, ist bei Ausführung des erfindungsgemäßen Verfahrens in der Lage, eine Durchsage zu tätigen, die von sämtlichen im Schienenfahrzeug 10 befindlichen Fahrgästen akustisch wahrnehmbar ist. Hierzu wird in einem Verfahrensschritt A ein akustisches Sprachsignal 46 des Zugbegleiters 44 mittels einer Sprecheinrichtung 50 aufgenommen. Das akustische Sprachsignal 46 umfasst bei dem in Figur 1 gezeigten Ausführungsbeispiel eine vom Zugbegleiter 44 getätigte mündliche Durchsage. Die Durchsage dient beispielsweise zur Informationsvermittlung an Fahrgäste, die sich im Schienenfahrzeug 10 befinden. So können beispielsweise Informationen in Bezug auf eine kommende Haltestation des Schienenfahrzeugs 10 und entsprechende Informationen zu Weiterfahrtmöglichkeiten durchgesagt werden.

Die Sprecheinrichtung 50 ist als mobiles Endgerät 51 ausgebildet. Um die Aufnahme zu starten, betätigt der Zugbegleiter 44 eine Benutzerschnittstelle 52 der Sprecheinrichtung 50. Die Sprecheinrichtung 50 umfasst eine Mikrophoneinheit 53 mit einem Akustiksensor 55 zum Aufnehmen des akustischen Sprachsignals 46. Die Mikrophoneinheit 53 wandelt das akustische Sprachsignal 46 in ein elektromagnetisches Sprachsignal um. Das elektromagnetische Sprachsignal wird an eine Recheneinheit 70 auf einem Weg über eine Drahtlosschnittstelle 62 der Sprecheinrichtung 50, einen im Fahrgastraum 13 angeordneten WLAN-Zugangspunkt 66 und ein Switchelement 63 übertragen.

In einem Verfahrensschritt B wird das akustische Sprachsignal mittels der Ausgabeeinrichtungen 2, 4 ausgegeben, so dass sämtliche im Fahrgastraum 13 befindliche Fahrgäste das ausgegebene akustischen Sprachsignal wahrnehmen können.

Die Beacon-Elemente 29, 31, 33, 35 stellen in einem Verfahrensschritt C ein Ortsermittlungssignal 58 bereit, welches von den Identifikationssignalen 36, 38, 40, 42 gebildet wird. Die Identifikationssignale 36, 38, 40, 42 sind elektromagnetische Signale, welche jeweils eine Identifikationsinformation enthalten, mittels derer das jeweilige Beacon-Element 29, 31, 33, 35 identifizierbar ist. Die jeweilige Identifikationsinformation wird unter Anwendung des Bluetooth-Standards implementiert. Die Sprecheinrichtung 50 empfängt das Ortsermittlungssignal 58 mittels einer Empfangseinheit 56, welche als Bluetooth-Schnittstelle ausgebildet ist.

In einem Verfahrensschritt E wird ein Ort der Sprecheinrichtung 50 relativ zu den Ausgabeeinrichtungen 2, 4 ermittelt:
Dazu wird zunächst der Ort der Sprecheinrichtung innerhalb des Schienenfahrzeugs 10 ermittelt. Die Sprecheinrichtung 50 sendet die empfangenen Identifikationssignale 36, 38, 40, 42 mittels der Drahtlosschnittstelle 62 an eine Positionsdatenbank 64, welche innerhalb des Schienenfahrzeugs 10 angeordnet ist. Dazu werden die Identifikationssignale 36, 38, 40, 42 drahtlos an den WLAN-Zugangspunkt 66 gesendet, welcher mit der Positionsdatenbank 64 über das Switchelement 63 datentechnisch verbunden ist. Anhand einer in der Positionsdatenbank 64 gespeicherten Zuordnungstabelle 68 ordnet die Recheneinheit 70, die mit der Positionsdatenbank 64 datentechnisch gekoppelt ist, den Identifikationssignalen 36, 38, 40, 42 jeweils eine Transponder-Ortsinformation 65, 67, 69, 71, welche den Ort des jeweiligen Transponderelements 28, 30, 32, 34 repräsentiert, zu. Die Transponder-Ortsinformationen 65, 67, 69, 71 werden also durch die Positionsdatenbank 64 bereitgestellt, welche als eine Datenverarbeitungseinrichtung 72 zum Bereitstellen der Transponder-Ortsinformationen 65, 67, 69, 71 vorgesehen ist. Die Datenverarbeitungseinrichtung 72 ist in einer Containereinheit 73 für Bordnetzkomponenten des Schienenfahrzeugs 10 angeordnet. Die Datenverarbeitungseinrichtung 72 ist außerhalb des jeweiligen Transponderelements 65, 67, 69, 71 angeordnet.

Die Transponder-Ortsinformation 65 für das Beacon-Element 29 enthält beispielsweise eine Zugnummer 74, die Wagennummer 14 sowie die Sitznummer 17. Die Transponder-Ortsinformation 67 für das Beacon-Element 31 enthält beispielsweise die Zugnummer 74, die Wagennummer 14 sowie die Sitznummern 19 und 21. Die Transponder-Ortsinformation 69 für das Beacon-Element 33 enthält beispielsweise die Zugnummer 74, die Wagennummer 14 sowie die Sitznummern 23 und 25. Die Transponder-Ortsinformation 71 für das Beacon-Element 35 enthält beispielsweise die Zugnummer 74, die Wagennummer 14 sowie die Sitznummer 27. Die Transponder-Ortsinformationen 65, 67, 69, 71 geben folglich an, an welchem Sitz bzw. an welchen Sitzen, in welchem Wagen und in welchem Zug sich ein jeweiliges Beacon-Element 29, 31, 33 oder 35 befindet.

Für die Ermittlung des Ortes der Sprecheinrichtung 50 innerhalb des Schienenfahrzeugs 10 basierend auf der Kenntnis der Transponder-Ortsinformationen 65, 67, 69, 71 wird der Ort der Sprecheinrichtung 50 relativ zu den Transponderelementen 28, 30, 32, 34 bestimmt. Dazu bestimmt die Sprecheinrichtung 50 eine Intensität des jeweiligen Identifikationssignals 36, 38, 40, 42. Die Sprecheinrichtung 50 sendet eine Intensitätsinformation, welche für die jeweilige Intensität repräsentativ ist, mittels der Drahtlosschnittstelle 62 an die Recheneinheit 70. Der Ort der Sprecheinrichtung 50 relativ zum Transponderelement 28, 30, 32, 34 wird mittels der Recheneinheit 70 unter Anwendung von Triangulation ermittelt. Für die Bestimmung des Ortes der Sprecheinrichtung 50 relativ zu einer Längserstreckung 11 des Schienenfahrzeugs 10 ist der Empfang von zwei Identifikationssignalen, insbesondere der Identifikationssignale 36 und 38 ausreichend.

Die Recheneinheit 70 nutzt die Transponder-Ortsinformationen 65, 67, 69, 71 sowie den Ort der Sprecheinrichtung 50 relativ zu den Transponderelementen 28, 30, 32, 34 für die Ermittlung des Ortes der Sprecheinrichtung 50 innerhalb des Schienenfahrzeugs 10.

Die Recheneinheit 70 umfasst eine Speichereinheit 75, welche Informationen zu einem jeweiligen Ort und einer jeweiligen Ausrichtung der Lautsprecher 102, 104 bzw. 106, 108 der Ausgabeeinrichtungen 2 bzw. 4 umfasst. Unter Kenntnis des Ortes der Sprecheinrichtung 50 innerhalb des Schienenfahrzeugs 10 und der Orte der Ausgabeeinrichtungen 2, 4 ermittelt die Recheneinheit 70 den Ort der Sprecheinrichtung relativ zu den Ausgabeeinrichtungen 2, 4.

In einem Verfahrensschritt F wird die Ausgabelautstärke der Ausgabeeinrichtungen 2, 4 in Abhängigkeit des Ortes der Sprecheinrichtung 50 relativ zu den Ausgabeeinrichtungen 2, 4 gesteuert. Insbesondere wird die Ausgabelautstärke in einem Verfahrensschritt G derart gesteuert, dass eine akustische Rückkopplung zwischen den Ausgabeeinrichtungen 2, 4 und der Sprecheinrichtung 50 vermieden wird.

Unter Kenntnis des Ortes der Sprecheinrichtung relativ zu den Ausgabeeinrichtungen 2, 4 sowie der jeweiligen Ausrichtung der Lautsprecher 102, 104, 106, 108 ermittelt die Recheneinheit 70, ob eine Rückkopplung zwischen der Sprecheinrichtung 50 und einer oder mehreren der Ausgabeeinrichtungen 2, 4 zu erwarten ist. Die eine oder mehreren Ausgabeeinrichtungen 2, 4 die für eine Rückkopplung in Betracht kommen, werden als Umgebungsausgabeeinrichtung(en) ausgewählt.

In dem in Fig. 1 gezeigten Schienenfahrzeug 10 wird die Ausgabeeinrichtung 2 als Umgebungsausgabeeinrichtung ausgewählt. Die Lautsprechereinheit 102 der Ausgabeeinrichtung 2 hat eine Ausrichtung in Richtung der Sprecheinrichtung 50 und liegt derart in der Umgebung der Sprecheinrichtung 50, dass bei einer Ausgabe des akustischen Sprachsignals 46 eine Rückkopplung zu erwarten ist. Um eine Rückkopplung zu vermeiden, steuert die Recheneinheit 70 die Ausgabelautstärke der Umgebungsausgabeeinrichtung 2. Beispielsweise wird die Ausgabelautstärke der Ausgabeeinrichtung 7 auf null eingestellt, indem die Umgebungsausgabeeinrichtung 2 abgeschaltet wird.

Die Ausgabeeinrichtung 2 weist eine Verstärkereinheit 3 und die Ausgabeeinrichtung 4 eine Verstärkereinheit 5 auf. Die Verstärkereinheit 3 dient zur Verstärkung des elektromagnetischen Sprachsignals, welches für die Lautsprechereinheiten 102 und 104 vorgesehen ist. Die Verstärkereinheit 5 dient zur Verstärkung des elektromagnetischen Sprachsignals, welches für die Lautsprechereinheiten 106 und 108 vorgesehen ist. Das Steuern der Ausgabelautstärke der Umgebungsausgabeeinrichtung 2 erfolgt, indem die Verstärkereinheit 3 der Umgebungsausgabeeinrichtung 2 gesteuert wird. Hierzu sendet die Recheneinheit 70 ein Lautstärkesteuerungssignal über das Switchelement 63 an die Verstärkereinheit 3.

## Patentansprüche

1. Verfahren zum Steuern einer Ausgabelautstärke wenigstens einer akustischen Ausgabeeinrichtung (2, 4) umfassend:
Aufnehmen (A) eines akustischen Sprachsignals (46) mittels einer Sprecheinrichtung (50),
Ausgeben (B) des akustischen Sprachsignals (46) mittels der wenigstens einen Ausgabeeinrichtung (2, 4) und
Ermitteln (E) eines Ortes der Sprecheinrichtung (50) relativ zu der wenigstens einen Ausgabeeinrichtung (2, 4),
wobei die Ausgabelautstärke der wenigstens einen Ausgabeeinrichtung (2, 4) in Abhängigkeit des Ortes gesteuert wird (F) **dadurch gekennzeichnet, dass** die Ausgabeeinrichtung (2, 4) eine Ausgabeeinrichtung eines Schienenfahrzeugs (10) ist und
der Ort der Sprecheinrichtung (50) basierend auf wenigstens einem Ortsermittlungssignal (58) ermittelt wird, welches von einem aktiven und/oder passiven Transponderelement (28, 30, 32, 24) ausgeht und von der Sprecheinrichtung (50) empfangen wird.

2. Verfahren nach Anspruch 1,
**dadurch gekennzeichnet, dass**
die Ausgabelautstärke derart gesteuert wird (G), dass eine akustische Rückkopplung zwischen der wenigstens einen Ausgabeeinrichtung (2, 4) und der Sprecheinrichtung (50) vermieden wird (G).

3. Verfahren nach Anspruch 1 oder 2,
**dadurch gekennzeichnet, dass**
die Sprecheinrichtung (50) das Ortsermittlungssignal (58) in Form eines elektromagnetischen Signals unter Anwendung des Bluetooth-Standards empfängt.

4. Verfahren nach wenigstens einem der vorhergehenden Ansprüche,
**dadurch gekennzeichnet, dass**
das passive Transponderelement ein RFID-Element umfasst und/oder
das aktive Transponderelement ein Beacon-Element (29, 31, 33, 35) umfasst.

5. Verfahren nach wenigstens einem der vorhergehenden Ansprüche,
**dadurch gekennzeichnet, dass**
der Ort der Sprecheinrichtung (50) basierend auf einer Intensität des Ortsermittlungssignals (58) ermittelt wird.

6. Verfahren nach wenigstens einem der vorhergehenden Ansprüche,
**dadurch gekennzeichnet, dass**
das Ortsermittlungssignal (58) ein Identifikationssignal (36, 38, 40, 42) zum Identifizieren des Transponderelements (28, 30, 32, 34) umfasst.

7. Verfahren nach Anspruch 6,
**dadurch gekennzeichnet, dass**
anhand einer Zuordnungstabelle (68) dem Identifikationssignal (36, 38, 40, 42) eine Transponder-Ortsinformation (65, 67, 69, 71), welche für den Ort des Transponderelements (28, 30, 32, 34) repräsentativ ist, zugeordnet wird und
der Ort der Sprecheinrichtung (50) unter Verwendung der Transponder-Ortsinformation (65, 67, 69, 71) ermittelt wird.

8. Verfahren nach Anspruch 7,
**dadurch gekennzeichnet, dass**
die Transponder-Ortsinformation (65, 67, 69, 71) durch eine Datenverarbeitungseinrichtung (72) bereitgestellt wird, welche außerhalb des Transponderelements (28, 30, 32, 34) angeordnet ist.

9. Verfahren nach wenigstens einem der vorhergehenden Ansprüche,
**dadurch gekennzeichnet, dass**
basierend auf dem Ort aus einer Mehrzahl von Ausgabeeinrichtungen (2, 4) wenigstens eine Umgebungsausgabeeinrichtung (2) ausgewählt wird, die in der Umgebung der Sprecheinrichtung (50), vorzugsweise mit einem Abstand von weniger als 10 m zur Sprecheinrichtung (50), angeordnet ist, und
das Steuern der Ausgabelautstärke durch Steuern der Ausgabelautstärke der wenigstens einen Umgebungsausgabeeinrichtung (2) erfolgt.

10. Verfahren nach Anspruch 9,
**dadurch gekennzeichnet, dass**
das Steuern durch ein Einstellen, insbesondere Abschalten, der Ausgabelautstärke erfolgt.

11. Verfahren nach Anspruch 9 oder 10,
**dadurch gekennzeichnet, dass**
die Ausgabeeinrichtungen (2, 4) jeweils wenigstens eine Lautsprechereinheit (102, 104, 106, 108) und wenigstens eine Verstärkereinheit (3, 5) umfassen,
basierend auf dem Ort aus einer Mehrzahl von Verstärkereinheiten (3, 5) wenigstens eine Umgebungsverstärkereinheit (3) ausgewählt wird, die in der Umgebung der Sprecheinrichtung (50) angeordnet ist, und
das Steuern der Ausgabelautstärke durch Steuern der Ausgangsleistung der wenigstens einen Umgebungsverstärkereinheit (3) erfolgt.

12. Verfahren nach wenigstens einem der vorhergehenden Ansprüche,
**dadurch gekennzeichnet, dass**
die Sprecheinrichtung (50) ein mobiles Endgerät (51) umfasst.

13. Schienenfahrzeug mit einer Anordnung zum Steuern einer Ausgabelautstärke wenigstens einer akustischen Ausgabeeinrichtung (2, 4) umfassend:
eine Sprecheinrichtung (50) zum Aufnehmen eines akustischen Sprachsignals,
eine Ermittlungseinheit zum Ermitteln eines Ortes der Sprecheinrichtung (50) relativ zu der wenigstens einen Ausgabeeinrichtung (2, 4),
eine Steuerungseinheit zum Steuern einer Ausgabelautstärke einer Ausgabe des akustischen Sprachsignals mittels der wenigstens einen Ausgabeeinrichtung (2, 4) in Abhängigkeit des Ortes,
die Ausgabeeinrichtung (2, 4) und
ein aktives Transponderelement (28, 30, 32, 34),
wobei die Sprecheinrichtung (50) eine Empfangseinheit zum Empfangen eines von dem aktiven Transponderelement (28, 30, 32, 24) ausgesendeten Ortsermittlungssignals (58) umfasst und wobei die Ermittlungseinheit ausgebildet ist, den Ort der Sprecheinrichtung (50) basierend auf dem wenigstens einen Ortsermittlungssignal (58) zu ermitteln.

## Claims

1. Method for controlling an output volume of at least one acoustic output device (2, 4) comprising:
recording (A) an acoustic voice signal (46) by means of a speech-recording device (50),
outputting (B) the acoustic voice signal (46) by means of the at least one output device (2, 4) and
determining (E) a location of the speech-recording device (50) relative to the at least one output device (2, 4), wherein the output volume of the at least one output device (2, 4) is controlled (F) as a function of the location,
**characterised in that**
the output device (2, 4) is an output device in a rail vehicle (10) and
the location of the speech-recording device (50) is determined based on at least one location-determination signal (58) that emanates from an active and/or passive transponder element (28, 30, 32, 24) and that is received by the speech-recording device (50).

2. Method according to claim 1,
**characterised in that**
the output volume is controlled in such a way (G) that acoustic feedback between the at least one output device (2, 4) and the speech-recording device (50) is avoided (G).

3. Method according to claim 1 or 2,
**characterised in that**
the speech-recording device 50) receives the location-determination signal (58) in the form of an electromagnetic signal using the Bluetooth standard.

4. Method according to one of the preceding claims,
**characterised in that**
the passive transponder element comprises an RFID-element and/or
the active transponder element comprises a beacon element (29, 31, 33, 35).

5. Method according to one of the preceding claims,
**characterised in that**
the location of the speech-recording device (50) is determined based on an intensity of the location-determination signal (58) .

6. Method according to one of the preceding claims,
**characterised in that**
the location-determination signal (58) comprises an identification signal (36, 38, 40, 42) to identify the transponder element (28, 30, 32, 34).

7. Method according to claim 6,
**characterised in that**,
based on a mapping table (68), transponder location information (65, 67, 69, 71) that is representative of the location of the transponder element (28, 30, 32, 34) is assigned to the identification signal (36, 38, 40, 42) and the location of the speech-recording device (50) is determined using the transponder location information (65, 67, 69, 71).

8. Method according to claim 7,
**characterised in that**
the transponder location information (65, 67, 69, 71) is provided by a data processing device (72), which is arranged outside the transponder element (28, 30, 32, 34).

9. Method according to at least one of the preceding claims,
**characterised in that**,
based on the location, at least one ambient output device (2) is selected out of a plurality of output devices (2, 4) that are arranged in the vicinity of the speech-recording device (50), preferably with a distance of less than 10 m from the speech-recording device (50), and
the control of the output volume is achieved by controlling the output volume of the at least one ambient output device (2) .

10. Method according to claim 9,
**characterised in that**
the controlling is achieved by adjusting, in particular by switching off, the output volume.

11. Method according to claim 9 or 10,
**characterised in that**
the output devices (2, 4) comprise in each case at least one speaker unit (102, 104, 106, 108) and at least one amplifier unit (3, 5),
at least one ambient amplifier unit (3) that is arranged in the vicinity of the speech-recording device (50), is selected out of a plurality of amplifier units (3, 5), based on the location and
the controlling of the output volume is achieved by controlling the output of the at least one ambient amplifier unit (3).

12. Method according to at least one of the preceding claims,
**characterised in that**
the speech-recording device (50) comprises a mobile terminal (51) .

13. Rail vehicle with an arrangement for controlling an output volume of at least one acoustic output device (2, 4) comprising:
a speech-recording device (50) to record an acoustic voice signal,
a determination unit to determine a location of the speech-recording device (50) relative to the at least one output device (2, 4),
a control unit to control an output volume of an output of the acoustic voice signal by means of at least one output device (2, 4) as a function of the location,
the output device (2, 4) and
an active transponder element (28, 30, 32, 34),
wherein the speech-recording device (50) comprises a receiving unit for receiving a location-determination signal (58) output by the active transponder element (28, 30, 32, 34) and wherein the determination unit is embodied to determine the location of the speech-recording device (50) based on the at least one location-determination signal (58).

## Revendications

1. Procédé de commande du volume sonore d'émission d'au moins un dispositif (2, 4) d'émission acoustique, comprenant :
l'enregistrement (A) d'un signal (46) vocal acoustique au moyen d'un dispositif (50) de conversation,
l'émission (B) du signal (46) vocal acoustique au moyen du au moins un dispositif (2, 4) d'émission et
la détermination (E) de l'emplacement du dispositif (50) de conversation par rapport au au moins un dispositif (2, 4) d'émission,
dans lequel on commande (F) le volume sonore d'émission du au moins un dispositif (2, 4) d'émission en fonction de l'emplacement,
**caractérisé en ce que**
le dispositif (2, 4) d'émission est un dispositif d'émission d'un véhicule (10) ferroviaire et
on détermine l'emplacement du dispositif (50) de conversation sur la base d'au moins un signal (58) de détermination de l'emplacement, qui part d'un élément (28, 30, 32, 24) de transpondeur actif et/ou passif et qui est reçu par le dispositif (50) de conversation.

2. Procédé suivant la revendication 1,
**caractérisé en ce que**
l'on commande (G) le volume sonore d'émission de manière à empêcher (G) une réaction acoustique entre le au moins un dispositif (2, 4) d'émission et le dispositif (50) de conversation.

3. Procédé suivant la revendication 1 ou 2,
**caractérisé en ce que**
le dispositif (50) de conversation reçoit le signal (58) de détermination de l'emplacement sous la forme d'un signal électromagnétique, en utilisant la norme Bluetooth.

4. Procédé suivant au moins l'une des revendications précédentes,
**caractérisé en ce que**
l'élément de transpondeur passif comprend un élément RFID et/ou
l'élément de transpondeur actif comprend un élément (29, 31, 33, 35) de balise.

5. Procédé suivant au moins l'une des revendications précédentes,
**caractérisé en ce que**
l'on détermine l'emplacement du dispositif (50) de conversation sur la base d'une intensité du signal (58) de détermination de l'emplacement.

6. Procédé suivant au moins l'une des revendications précédentes,
**caractérisé en ce que**
le signal (58) de détermination de l'emplacement comprend un signal (36, 38, 40, 42) d'identification pour l'identification de l'élément (28, 30, 32, 34) de transpondeur.

7. Procédé suivant la revendication 6,
**caractérisé en ce que**
l'on associe à l'aide d'une table (68) d'association, au signal (36, 38, 40, 42) d'identification, une information (65, 67, 69, 71) d'emplacement de transpondeur représentative de l'emplacement de l'élément (28, 30, 32, 34) de transpondeur et on détermine l'emplacement du dispositif (50) de conversation, en utilisant l'information (65, 67, 69, 71) d'emplacement du transpondeur.

8. Procédé suivant la revendication 7,
**caractérisé en ce que**
l'on procure l'information (65, 67, 69, 71) d'emplacement du transpondeur par un dispositif (72) de traitement de données, qui est disposé à l'extérieur de l'élément (28, 30, 32, 34) de transpondeur.

9. Procédé suivant au moins l'une des revendications précédentes,
**caractérisé en ce que**,
sur la base de l'emplacement d'une pluralité de dispositifs (2, 4) d'émission, on choisit au moins un dispositif (2) d'émission d'environnement, qui est disposé dans l'environnement du dispositif (50) de conversation, de préférence à une distance de moins de 10 m du dispositif (50) de conversation, et
la commande du volume sonore d'émission a lieu par commande du volume sonore d'émission du au moins un dispositif (2) d'émission d'environnement.

10. Procédé suivant la revendication 9,
**caractérisé en ce que**
la commande s'effectue par réglage, notamment par coupure, du volume sonore d'émission.

11. Procédé suivant la revendication 9 ou 10,
**caractérisé en ce que**
les dispositifs (2, 4) d'émission comprennent chacun au moins une unité (102, 104, 106, 108) de haut-parleur et au moins une unité (3, 5) d'amplificateur,
sur la base de l'emplacement d'une pluralité d'unités (3, 5) d'amplificateur, on choisit au moins une unité (3) de haut-parleur d'environnement, qui est disposée dans l'environnement du dispositif (50) de conversation, et
la commande du volume sonore d'émission s'effectue par commande de la puissance de sortie de la au moins une unité (3) d'amplificateur d'environnement.

12. Procédé suivant au moins l'une des revendications précédentes,
**caractérisé en ce que**
le dispositif (50) de conversation comprend un terminal (51) mobile.

13. Véhicule ferroviaire, comprenant un système de commande d'un volume sonore d'émission d'au moins un dispositif (2, 4) d'émission acoustique, comprenant :
un dispositif (50) de conversation de réception d'une signal vocal acoustique,
une unité de détermination pour déterminer l'emplacement du dispositif (50) de conversation par rapport au au moins un dispositif (2, 4) d'émission,
une unité de commande pour commander un volume sonore d'émission d'une émission du signal vocal acoustique, au moyen du au moins un dispositif (2, 4) d'émission, en fonction de l'emplacement,
le dispositif (2, 4) d'émission et
un élément (28, 30, 32, 34) de transpondeur actif,
dans lequel le dispositif (50) de conversation comprend une unité de réception pour recevoir un signal (58) de détermination d'emplacement envoyé par l'élément (28, 30, 32, 24) de transpondeur actif, et dans lequel l'unité de détermination est constituée pour déterminer l'emplacement du dispositif (50) de conversation sur la base du au moins un signal (58) de détermination d'emplacement.
